# EUROPEAN PATENT SPECIFICATION

(11) **EP 2 303 896 B1**
(45) Date of publication and mention of the grant of the patent: **06.11.2013**
(21) Application number: 10701152.0
(22) Date of filing: 26.01.2010
(51) Int. Cl.: C07F 7/18, C08J 5/24

(54) **SILANE COUPLING AGENTS FOR PRINTED CIRCUIT BOARDS**
SILANKOPPLUNGSMITTEL FÜR BESTÜCKTE LEITERPLATTEN
AGENTS DE COUPLAGE AU SILANE DESTINÉS À DES CARTES DE CIRCUITS IMPRIMÉS

(30) Priority: 24.02.2009 US 391500
(43) Date of publication of application: 06.04.2011
(73) Proprietor: International Business Machines Corporation, Armonk, NY 10504 (US)
(72) Inventor: KUCZYNSKI, Joseph, Rochester, Minnesota 55901-1407 (US); GELORME, Jeffrey, Donald, Yorktown Heights, NY 10598 (US)
(74) Representative: Williams, Julian David
(86) International application number: PCT/EP2010/050866
(87) International publication number: WO 2010/097261

(56) References cited:
- EP-A1- 0 837 090
- JP-A- 2003 138 127
- US-A- 3 517 001

## Description

### Field of the Invention

The present invention is directed to printed circuit boards.

### Background of the Invention

The basic concept behind a coupling agent is to join two disparate surfaces. In the case of printed circuit boards (PCBs), a silane coupling agent is often used to join a coating, e.g., a varnish such as an epoxy-based resin, to a substrate, e.g. glass cloth, to define a laminate, or laminated structure. The silane coupling agent typically consists of an organofunctional group to bind to the coating and a hydrolyzable group that binds to the surface of the substrate. In particular, the alkoxy groups on silicon hydrolyze to silanols, either through the addition of water or from residual water on the inorganic surface. Subsequently, the silanols react with hydroxyl groups on the inorganic surface to form an oxane bond (Si-O-Si) and eliminate water.

EPO 837,090 describes a conventional silane coupling agent for printed circuit board applications. JP 2003 138127 describes a conventional filler for thermosetting polyphenylene ether resin. Conventional nitrogen containing organosilicon materials are described in US 2,517,001.

One problem experienced with PCBs is conductive anodic filament (CAF), which is a copper corrosion byproduct that emanates from the anode of a circuit and "grows" subsurface toward the cathode, frequently along separated fiber-epoxy interfaces. With PCBs, anode/cathode pairs are typically plated through holes. CAF can result in catastrophic failure of PCBs, which in some instances can cause fires. The bond between the varnish and substrate is understood to be an important factor in CAF. Thus, the silane coupling agent is an important consideration in the laminate.

For the specific case of epoxy-based laminates, the organofunctional group that has been found to exhibit desirable performance based on numerous criteria is vinylbenzylaminoethylaminopropyl and also benzylaminoethylaminopropyl. Silane coupling agents, which include this organofunctional group, are thought to covalently bond to the epoxide functional groups of the traditional epoxy-based resin, such as the well known FR4 epoxy resins, through the secondary nitrogens of the amino groups. While a plethora of silane coupling agents exist, the industry workhorse for coupling epoxy-based resins has been vinylbenzylaminoethylaminopropyl-trimethoxysilane (commercially available as Dow Coming Z-6032).

As the PCB industry has migrated away from traditional FR4 epoxy resins (due to lead-free requirements and the higher soldering temperatures associated with tin-silver-copper alloys), silane coupling agents originally developed for those epoxies have not kept pace. That is, vinylbenzylaminoethylaminopropyltrimethoxy silane is still the coupling agent utilized to couple, or bond, the glass cloth substrate to the laminate varnish. However, current varnishes are no longer comprised of FR4 epoxies, rather they are more likely to be bismaleimide triazine (BT) resins or polyphenylene oxide/trially-isocyanurate (PPO/TAIC) interpenetrating networks.

Consequently, a need exists in the industry for a silane coupling agent designed for current resin systems.

### Summary of the Invention

In accordance with the present invention, there is now provided a printed circuit board comprising: a substrate; a varnish coating on the substrate; and a silane coupling agent situated between the varnish coating and substrate so as to couple the varnish coating to the substrate, the silane coupling agent defined by the following formula: 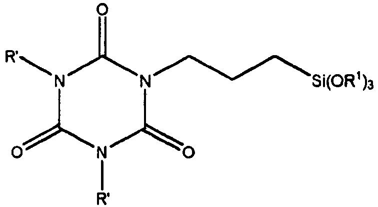 wherein at least one R' is an allyl and the other one is hydrogen, an alkyl, a cycloalkyl, an aryl, a heteroaryl, a non-aromatic heterocyclic ring, or an allyl; and R¹ is an alkyl, a cycloalkyl, an aryl, a heteroaryl, a non-aromatic heterocyclic ring, or an allyl.

Viewing the present invention from another aspect there is provided a method of making a printed circuit board comprising: applying a silane coupling agent to a substrate, the silane coupling agent defined by the following formula: 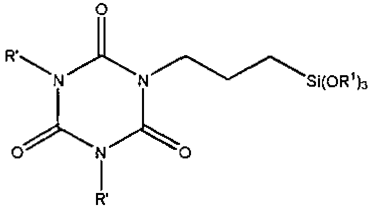 wherein at least one R' is an allyl and the other one is hydrogen, an alkyl, a cycloalkyl, an aryl, a heteroaryl, a non-aromatic heterocyclic ring, or an allyl; and R¹ is an alkyl, a cycloalkyl, an aryl, a heteroaryl, a non-aromatic heterocyclic ring, or an allyl; applying a varnish coating on the silane coupling agent wherein the silane coupling agent is situated between the varnish coating and the substrate; and subjecting the substrate, silane coupling agent, and varnish coating to curing conditions so as to define a printed circuit board.

### Detailed Description

In accordance with an embodiment of the invention, there is provided a silane coupling agent for printed circuit boards (PCBs), such as high-temperature PCBs.

The silane coupling agent is defined by the following formula: 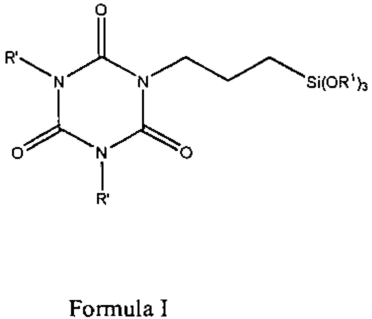 wherein at least one R' is an allyl and the other one is hydrogen, an alkyl, a cycloalkyl, an aryl, a heteroaryl, a non-aromatic heterocyclic ring, or an allyl; and R¹ is an alkyl, a cycloalkyl, an aryl, a heteroaryl, a non-aromatic heterocyclic ring, or an allyl.

In one example, each R' is an an allyl. In another, example, R¹ is an alkyl group. In yet another example, each R' is an allyl and R¹ represents an alkyl group having 1 to 18 carbon atoms. In another example, at least one R¹ group is a methyl group. In still another example, the silane coupling agent is:

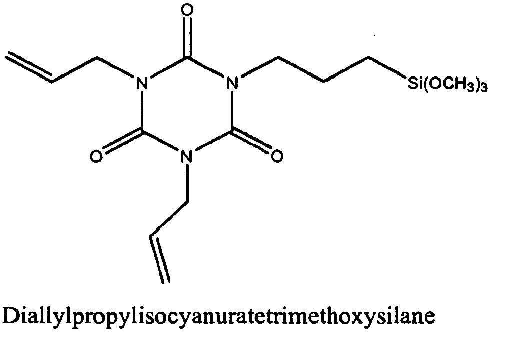

The silane coupling agent of Formula I incorporates an allylisocyanurate ligand as the organofunctional group and is designed to interact with current resin systems, such as polyphenylene oxide (PPO)/triallylisocyanurate (TAIC) resins. In particular, the allyl group(s) of the silane coupling agent can co-react with the allyl group(s) of the TAIC as the varnish cures to form a crosslinked resin tightly bound to the glass fibers of the substrate. Although the polyphenylene oxide (PPO)/triallylisocyanurate (TAIC) resins have been identified herein as suitable for coupling to glass fiber substrates via the silane coupling agent, it is contemplated that any ethylenic unsaturated monomer may be used as a varnish. To that end, in addition to TAIC (or its diallyl analog), vinyl- or methacryl-terminated PPO, any of the diallyl ethers of bisphenol (as described in U.S. Patent No. 4,774,282, the contents of which is expressly incorporated by reference herein in its entirety), or allyl-modified aryl cyanate esters (e.g., 1-allyl-2-cyanatobenzene), and the like, may be used.

And, while the silane coupling agent generally may be synthesized by methods known in the art, a schematic diagram outlining a proposed reaction mechanism for synthesizing the silane coupling agent of Formula I is shown below.

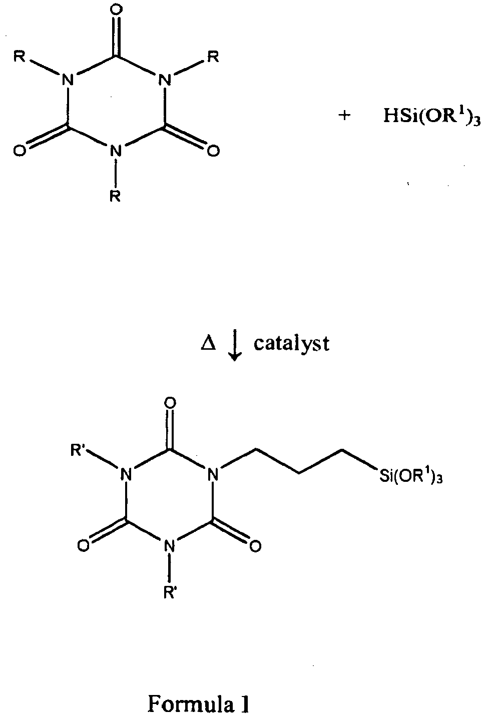

In the above schematic, concerning the allylisocyanurate ligand, at least two of the R groups are an allyl and the remaining R group is hydrogen, an alkyl, a cycloalkyl, an aryl, a heteroaryl, a non-aromatic heterocyclic ring, or an allyl; and R¹ is an alkyl, a cycloalkyl, an aryl, a heteroaryl, a non-aromatic heterocyclic ring, or an allyl. In one example, the allylisocyanurate ligand is TAIC, i.e., each R group is an ally, and the silicon hydride compound is trimethoxysilicon hydride, HSi(OCH₃)₃, i.e., R¹ is a methyl, such that the resulting silane coupling agent is diallylpropylisocyanurate trimethoxysilane. In another example, each R is an allyl. In yet another example, R¹ is an alkyl group. In still another example, each R is an allyl and R¹ represents an alkyl group having 1 to 18 carbon atoms.

Further concerning synthesis of the silane coupling agent, the allylisocyanurate ligand is reacted with the silicon hydride compound to reduce the alkene functionality of the allylisocyanurate ligand by adding across a double bond. This reaction takes place in the presence of heat (Δ) and a catalyst, such as transition metal catalyst, e.g., chloroplatinic acid. Judicious selection of the reaction conditions and stoichiometry is thought to limit the reactivity to a single allyl group of TAIC. The catalyst can be used at the 3-20 weight percent range based on total weight of reactants. In another example, the weight percent range can be from 4-8 and, in another example, the weight percent can be 5. The reaction temperature can range from 55-120°C. The completeness of the reaction can be determined by measuring the exotherm (via differential scanning calorimetry). Representative reaction times are in the 15-20 hr range. The reaction can be carried out in toluene or other suitable solvents. The reaction product can be isolated by stripping off the solvent via rotary evaporation or other suitable technique known to those skilled in the art. And, if necessary, fractional distillation can be used to separate the allylpropyl-isocyanurate derivatives. Concerning the catalyst, transition metal catalysts, such as platinum catalysts, are suitable for use in the synthesis process. Examples of platinum catalysts include chloroplatinic acid as well as those disclosed in U.S. Patent No. 5,260,399, the contents of which is expressly incorporated by reference herein in its entirety. Also, Wilkinson's catalyst, RhCl[(C₆H₅)₃P]₃], can be used. Ashby's Catalyst (1.75 wt percent platinum in ethanol) can also be used for such hydrosilation reactions, as well as the Lamoreaux catalyst (3.5wt % platinum in octanol), and the Karstedt catalyst (Pt₂{[(CH₂ = CH)Me₂Si])₂O}])₃}]). And, other representative examples include RhX(CO)(PR₃)₂; RhH(CO)[(C₆ H₅)₃P]₃; IrCl(CO)[(C₆ H₅)₃P]₂; IrI(CO)[(C₆ H₅)₃P]₂; IrH(CO)[(C₆ H₅)₃P]₃; Pt[(C₆ H₅)₃ P]₄; trans-Pt[(C₆ H₅)₃P]₂Cl₂; cis-Pt[(C₆H₅)₃P]₂C₁₂; Pt[(C₆H₅)₃P]₂(C₂H₄); Pt[(C₆ H₅)₃P]₂O₂; trans-PtHCl[(C₆ H₅)₃P]₂; cis-PtHCl[(C₆H₅)₃P]₂; Pt(PF₃)₄; Pd[(C₆H₅)₃P]₂Cl₁₂; Pd[(C₆H₅)₃P]₄; Pd[(C₆H₅)₃P]₂(CH₃ CO₂)₂; Ni[(C₆ H₅)₃P]₄; Ni[(C₆ H₅)₃P]₂Cl₂; Co[(C₆ H₅)₃P]₂Cl₂; and Ru[(C₆ H₅)₃P]₃Cl₂.

The resulting silane coupling agent of Formula I can couple, or bond, the varnish coating to the PCB substrate, e.g. glass cloth, to define a laminate, or laminated PCB. In particular, the resulting silane coupling agent can be applied to the substrate via known means, such as a dip coating process. Then, the treated substrate, e.g., glass substrate, is coated with a varnish, such as PPO/TAIC varnish, via means known in the art. After which, the laminate is subjected to curing conditions, e.g., heated under vacuum, as known in the art, which results in a crosslinked phase that is covalently bound to the glass fibers. And, as with the commercially available silanes, hydrolysis of the trialkoxy groups yields a silanol that reacts with hydroxyl groups on the glass surface to form Si-O-Si bonds upon loss of water. Additionally, the propyl group to which the trialkoxysilane is attached is hydrophobic, further retarding ingress of water to the resin/glass interface and improving CAF resistance.

## Claims

1. A printed circuit board comprising:
a substrate;
a varnish coating on the substrate; and
a silane coupling agent situated between the varnish coating and substrate so as to couple the varnish coating to the substrate, the silane coupling agent defined by the following formula: 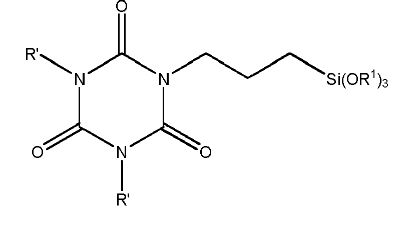 wherein at least one R' is an allyl and the other one is hydrogen, an alkyl, a cycloalkyl, an aryl, a heteroaryl, a non-aromatic heterocyclic ring, or an allyl; and R¹ is an alkyl, a cycloalkyl, an aryl, a heteroaryl, a non-aromatic heterocyclic ring, or an allyl.

2. The printed circuit board of claim 1 wherein each R' is an allyl.

3. The printed circuit board of claim 1 wherein R¹ represents an alkyl group.

4. The printed circuit board of claim 1 wherein each R' is an allyl and R¹ represents an alkyl group having 1 to 18 carbon atoms.

5. The printed circuit board of claim 1 wherein the silane coupling agent is

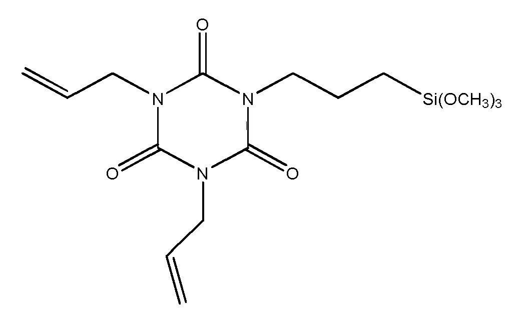

6. The printed circuit board of claim 1 wherein the substrate includes glass and the varnish coating is a polyphenylene oxide/triallylisocyanurate resin.

7. A method of making a printed circuit board comprising:
applying a silane coupling agent to a substrate, the silane coupling agent defined by the following formula: 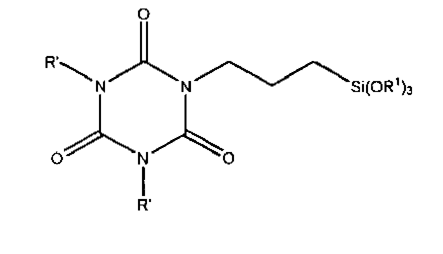
wherein at least one R' is an allyl and the other one is hydrogen, an alkyl, a cycloalkyl, an aryl, a heteroaryl, a non-aromatic heterocyclic ring, or an allyl; and R¹ is an alkyl, a cycloalkyl, an aryl, a heteroaryl, a non-aromatic heterocyclic ring, or an allyl;
applying a varnish coating on the silane coupling agent wherein the silane coupling agents is situated between the varnish coating and the substrate; and
subjecting the substrate, silane coupling agent, and varnish coating to curing conditions so as to define a printed circuit board.

8. The method of claim 7 wherein each R' is an allyl.

9. The method of claim 7 wherein R¹ represents an alkyl group.

10. The method of claim 7 wherein each R' is an allyl and R¹ represents an alkyl group having 1 to 18 carbon atoms.

11. The method of claim 7 wherein the silane coupling agent is

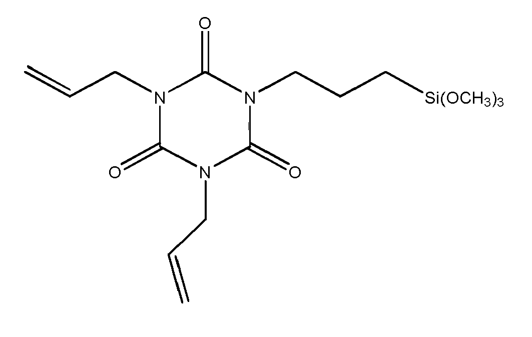

12. The method of claim 7 wherein the substrate includes glass and the varnish coating is a polyphenylene oxide/triallylisocyanurate resin.

## Patentansprüche

1. Gedruckte Leiterplatte, aufweisend:
ein Substrat;
eine Lackbeschichtung auf dem Substrat; und
ein Silankopplungsmittel, welches sich zwischen der Lackbeschichtung und dem Substrat befindet, um die Lackbeschichtung mit dem Substrat zu verbinden, wobei das Silankopplungsmittel durch die folgende Formel definiert ist: 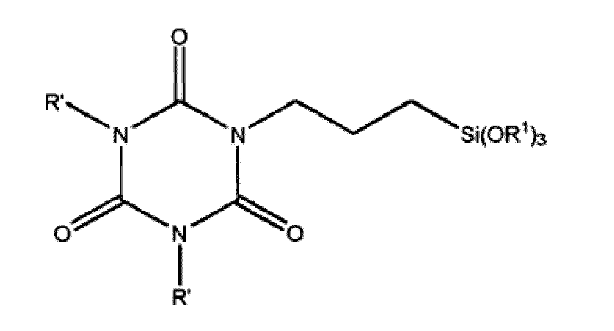 wobei mindestens ein Rest R' für eine Allylgruppe steht und der andere für Wasserstoff, eine Alkylgruppe, eine Cycloalkylgruppe, eine Arylgruppe, eine Heteroarylgruppe, einen nichtaromatischen heterocyclischen Ring oder eine Allylgruppe steht; und R¹ für eine Alkylgruppe, eine Cycloalkylgruppe, eine Arylgruppe, eine Heteroarylgruppe, einen nichtaromatischen heterocyclischen Ring oder eine Allylgruppe steht.

2. Gedruckte Leiterplatte nach Anspruch 1, wobei jeder Rest R' für eine Allylgruppe steht.

3. Gedruckte Leiterplatte nach Anspruch 1, wobei R¹ für eine Alkylgruppe steht.

4. Gedruckte Leiterplatte nach Anspruch 1, wobei jeder Rest R' für eine Allylgruppe steht und R¹ für eine Alkylgruppe mit 1 bis 18 Kohlenstoffatomen steht.

5. Gedruckte Leiterplatte nach Anspruch 1, wobei das Silankopplungsmittel 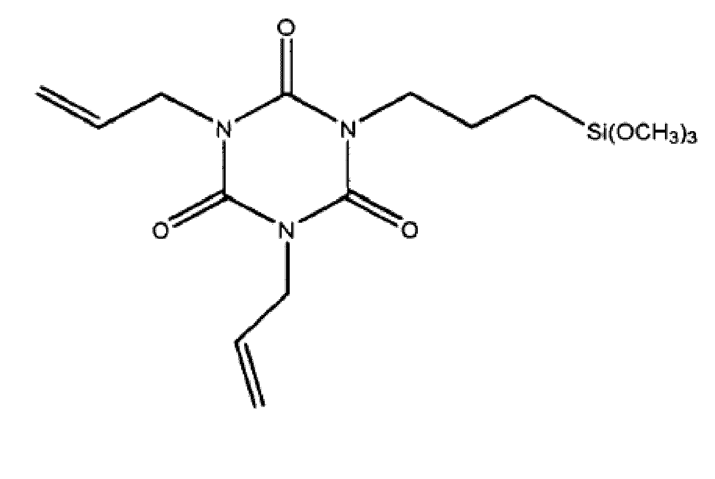 ist.

6. Gedruckte Leiterplatte nach Anspruch 1, wobei das Substrat Glas umfasst und die Lackbeschichtung ein Polyphenylenoxid/Triallylisocyanurat-Harz ist.

7. Verfahren zur Herstellung einer gedruckten Leiterplatte, aufweisend:
Aufbringen eines Silankopplungsmittels auf ein Substrat, wobei das Silankopplungsmittel durch die folgende Formel definiert ist: 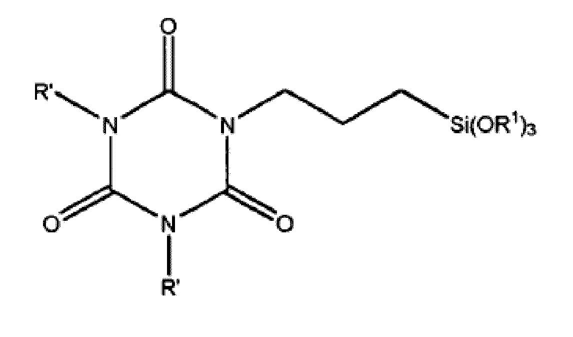
wobei mindestens ein Rest R' für eine Allylgruppe steht und der andere für Wasserstoff, eine Alkylgruppe, eine Cycloalkylgruppe, eine Arylgruppe, eine Heteroarylgruppe, einen nichtaromatischen heterocyclischen Ring oder eine Allylgruppe steht; und R¹ für eine Alkylgruppe, eine Cycloalkylgruppe, eine Arylgruppe, eine Heteroarylgruppe, einen nichtaromatischen heterocyclischen Ring oder eine Allylgruppe steht;
Aufbringen einer Lackbeschichtung auf das Silankopplungsmittel, wobei sich das Silankopplungsmittel zwischen der Lackbeschichtung und dem Substrat befindet; und
Anwenden von Härtungsbedingungen auf das Substrat, das Silankopplungsmittel und die Lackbeschichtung, um eine gedruckte Leiterplatte zu definieren.

8. Verfahren nach Anspruch 7, wobei jeder Rest R' für eine Allylgruppe steht.

9. Verfahren nach Anspruch 7, wobei R¹ für eine Alkylgruppe steht.

10. Verfahren nach Anspruch 7, wobei jeder Rest R' für eine Allylgruppe steht und R¹ für eine Alkylgruppe mit 1 bis 18 Kohlenstoffatomen steht.

11. Verfahren nach Anspruch 7, wobei das Silankopplungsmittel 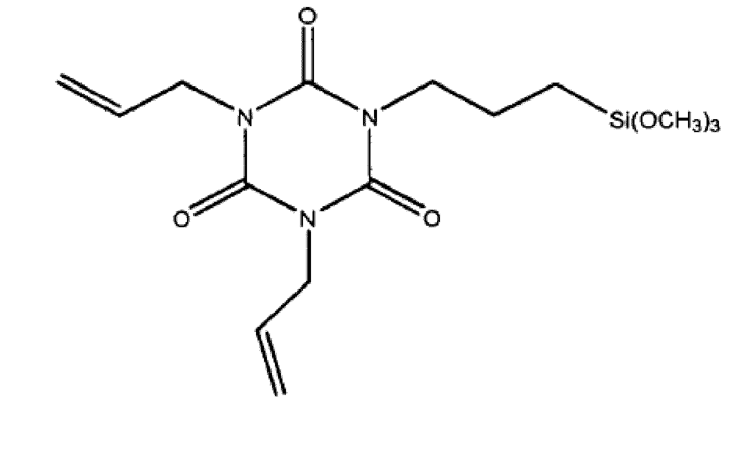 ist.

12. Verfahren nach Anspruch 7, wobei das Substrat Glas umfasst und die Lackbeschichtung ein Polyphenylenoxid/Triallylisocyanurat-Harz ist.

## Revendications

1. Carte de circuit imprimé comprenant :
un substrat ;
un revêtement de vernis sur le substrat ; et
un agent de couplage au silane situé entre le revêtement de vernis et le substrat de sorte à coupler le revêtement de vernis au substrat, l'agent de couplage au silane étant défini par la formule suivants : 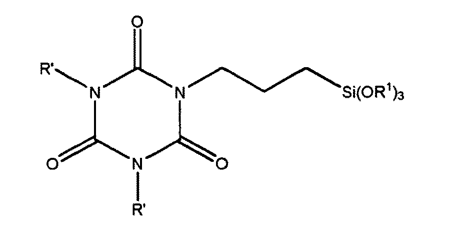 dans laquelle au moins un groupe R' est un groupe allyle et l'autre groupe est un atome d'hydrogène, un groupe alkyle, un groupe cycloalkyle, un groupe aryle, un groupe hétéroaryle, un cycle hétérocyclique non aromatique, ou un groupe allyle ; et R¹ est un groupe alkyle, un groupe cycloalkyle, un groupe aryle, un groupe hétéroaryle, un cycle hétérocyclique non aromatique ; ou un groupe allyle.

2. Carte de circuit imprimé selon la revendication 1 dans laquelle chaque groupe R' est un groupe allyle.

3. Carte de circuit imprimé selon la revendication 1 dans laquelle chaque groupe R¹ représente un groupe allyle.

4. Carte de circuit imprimé selon la revendication 1 dans laquelle chaque groupe R' est un groupe allyle et chaque groupe R¹ représente un groupe alkyle possédant de 1 à 18 atomes de carbone.

5. Carte de circuit imprimé selon la revendication 1 dans laquelle l'agent de couplage au silane est

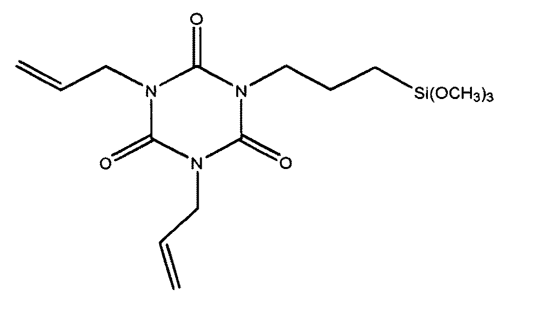

6. Carte de circuit imprimé selon la revendication 1 dans laquelle le substrat inclut du verre et le revêtement de vernis est une résine oxyde de polyphénylène/triallylisocyanurate.

7. Procédé de fabrication d'une carte de circuit imprimé comprenant :
l'application d'un agent de couplage au silane à un substrat, l'agent de couplage au silane étant défini par la formule suivants : 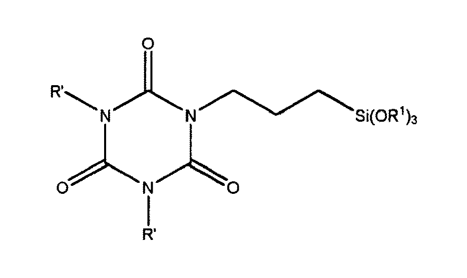
dans laquelle au moins un groupe R' est un groupe allyle et l'autre groupe est un atome d'hydrogène, un groupe alkyle, un groupe cycloalkyle, un groupe aryle, un groupe hétéroaryle, un cycle hétérocyclique non aromatique, ou un groupe allyle ; et le groupe R¹ est un groupe alkyle, un groupe cycloalkyle, un groupe aryle, un groupe hétéroaryle, un cycle hétérocyclique non aromatique, ou un groupe allyle ;
l'application d'un revêtement de vernis sur l'agent de couplage au silane où l'agent de couplage est situé entre le revêtement de vernis et le substrat ; et
la soumission du substrat, de l'agent de couplage au silane et du revêtement de vernis à des conditions de cuisson de sorte à définir une carte de circuit imprimé.

8. Procédé selon la revendication 7 dans lequel chaque groupe R' est un groupe allyle.

9. Procédé selon la revendication 7 dans lequel le groupe R¹ représente un groupe alkyle.

10. Procédé selon la revendication 7 dans lequel chaque groupe R' est un groupe allyle et le groupe R¹ représente un groupe alkyle possédant de 1 à 18 atomes de carbone.

11. Procédé selon la revendication 7 dans lequel l'agent de couplage au silane est

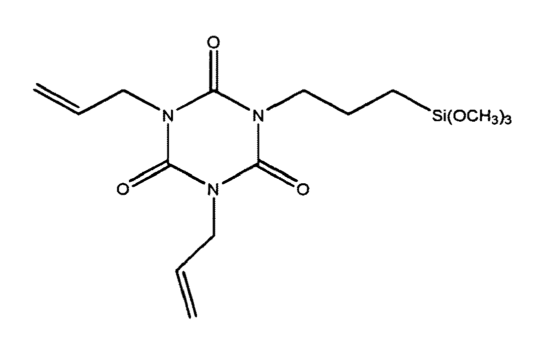

12. Procédé selon la revendication 7 dans lequel le substrat comprend du verre et le revêtement de vernis est une résine oxyde de polyphénylène/triallylisocyanurate.
